# FASCICULE DE BREVET EUROPEEN

(11) **EP 2 865 110 B1**
(45) Date de publication et mention de la délivrance du brevet: **17.08.2016**
(21) Numéro de dépôt: 13737342.9
(22) Date de dépôt: 20.06.2013
(51) Int. Cl.: H04B 10/2587, H01S 5/14, H04J 14/02

(54) **DISPOSITIF LUMINEUX REFLECHISSANT DESTINE A UN RESEAU D'ACCES OPTIQUE WDM PON COMPRENANT UNE SOURCE LUMINEUSE AVEC UN MILIEU DE GAIN OPTIQUE**
LICHT REFLEKTIERENDE VORRICHUNG FÜR EIN OPTISCHES WDM-PON-ZUGANGSNETZ MIT EINER LICHTQUELLE DIE EIN OPTISCHES VERSTÄRKUNGSMEDIUM UMFASST
LIGHT REFLECTING DEVICE FOR AN OPTICAL ACCESS WDM PON NETWORK COMPRISING A LIGHT SOURCE WITH AN OPTICAL GAIN MEDIUM

(30) Priorité: 22.06.2012 FR 1255933
(43) Date de publication de la demande: 29.04.2015
(73) Titulaire: Orange, 75015 Paris (FR)
(72) Inventeur: CHANCLOU, Philippe, F-22300 Lannion (FR); SALIOU, Fabienne, F-22300 Lannion (FR); CHARBONNIER, Benoît, F-22300 Lannion (FR)
(86) Numéro de dépôt international: PCT/FR2013/051443
(87) Numéro de publication internationale: WO 2013/190244

(56) Documents cités:
- EP-A1- 0 523 766
- EP-A1- 2 512 043
- FR-A1- 2 799 068
- US-B1- 6 384 966
- ELAINE WONG ED - ROPPELT M ET AL: "Current and next-generation broadband access technologies", OPTICAL FIBER COMMUNICATION CONFERENCE, 2011. TECHNICAL DIGEST. OFC/NFOEC, IEEE, 6 mars 2011 (2011-03-06), pages 1-24, XP031946142, ISBN: 978-1-4577-0213-6
- CHO K Y ET AL: "Long-Reach Coherent WDM PON Employing Self-Polarization-Stabilization Technique", JOURNAL OF LIGHTWAVE TECHNOLOGY, IEEE SERVICE CENTER, NEW YORK, NY, US, vol. 29, no. 4, 1 février 2011 (2011-02-01), pages 456-462, XP011329360, ISSN: 0733-8724, DOI: 10.1109/JLT.2010.2096800
- MARCO PRESI ET AL: "Stable self-seeding of R-SOAs for WDM-PONs", OPTICAL FIBER COMMUNICATION CONFERENCE, 2011. TECHNICAL DIGEST. OFC/NFOEC, IEEE, 6 mars 2011 (2011-03-06), pages 1-3, XP031946272, ISBN: 978-1-4577-0213-6
- SHINJI YAMASHITA ET AL: "Polarization Properties of a Reflective Fiber Amplifier Employing a Circulator and a Faraday Rotator Mirror", JOURNAL OF LIGHTWAVE TECHNOLOGY, IEEE SERVICE CENTER, NEW YORK, NY, US, vol. 14, no. 3, 1 mars 1996 (1996-03-01), XP011028468, ISSN: 0733-8724

## Description

La présente invention se rapporte au domaine des télécommunications. Au sein de ce domaine, l'invention se rapporte plus particulièrement aux réseaux d'accès optiques. Les réseaux d'accès optiques (FTTH pour "Fiber To The Home", fibre optique jusqu'au domicile) sont déployés pour acheminer des débits dits très hauts, c'est-à-dire au-delà du GigaBit/s jusqu'aux utilisateurs.

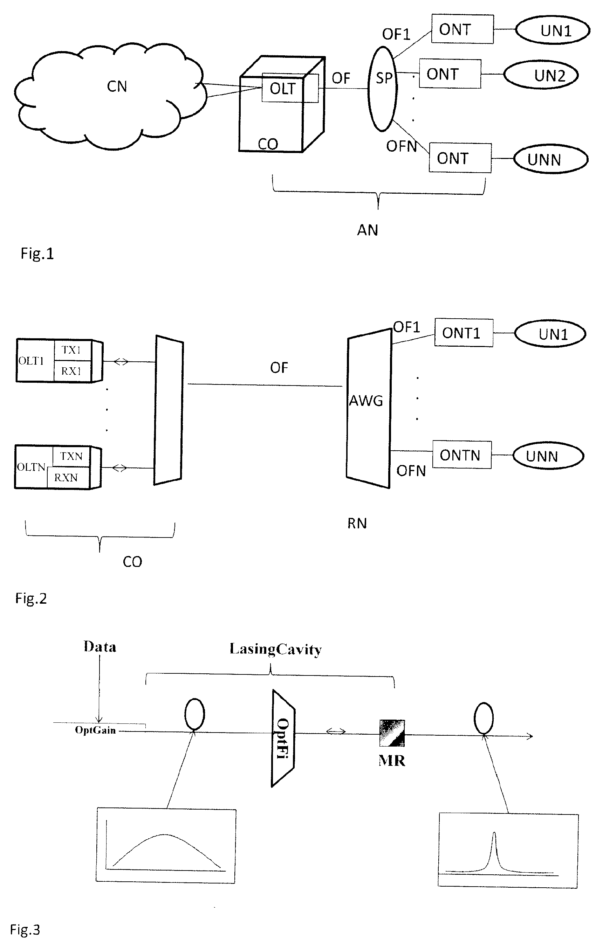

Parmi les différents réseaux d'accès optiques, on connait plus particulièrement les réseaux optiques passifs en étoile (PON, pour Passive Optical Network, en anglais) illustrés par la figure 1 basés sur une architecture fibre optique point-multipoint passive décrite notamment par D.W. Faulkner, A.L. Harmer, dans "Broadband Access Networks" (pour "réseaux d'accès large bande"), Networks and Optical Communications (NOC'97), Book, IOS, 1997 et par M. Nakamura, H. Ueda, S. Makino, T. Yokotani, et K. Oshima, dans "Proposal of networking by PON Technologies for full land ethernet services in FTTx", Journal of Lightwave Technology, volume 22, issue 11, pp. 2631 - 2640, November 2004.

Le réseau d'accès optique AN fait le lien entre les réseaux des utilisateurs UN1,...,UNN et le réseau coeur CN du réseau de communication. Le réseau d'accès optique de type PON débute, côté réseau coeur, par un équipement actif OLT (Optical Link Terminal) localisé généralement dans un central CO qui envoie et reçoit les signaux lumineux porteurs des données. Le réseau se termine, côté réseaux des utilisateurs, par des unités optiques ONT (Optical Network Terminal), parfois désignées par les acronymes ONU (Optical Network Unit) sachant qu'il y a autant d'ONT que de réseaux utilisateurs UN1,...,UNN.

On appelle signal descendant un signal se propageant du central vers un terminal client qui fait partie du réseau de l'utilisateur, et signal montant un signal se propageant dans le sens contraire.

L'architecture PON repose sur l'utilisation d'un coupleur/combineur optique SP (Splitter) passif, c'est-à-dire qui n'a pas besoin d'énergie électrique donc non alimenté, qui permet une topologie de 1 vers N avec une longueur d'onde montante et une longueur d'onde descendante. Chaque port de l'OLT est relié à un coupleur optique SP par une fibre optique OF unique. Le fonctionnement du coupleur SP est basé sur la seule propagation de la lumière à l'intérieur des fibres optiques. Dans le sens descendant, le coupleur SP diffuse sur des fibres optiques secondaires OF1 à OFN le signal optique en provenance de l'OLT vers les différents ONT. Chaque ONT filtre alors le signal destiné au seul utilisateur UN1,...ou UNN associé. Dans le sens montant, les signaux optiques en provenance des utilisateurs sont combinés au moyen d'un protocole d'accès (TDMA,...) respecté par chaque utilisateur. Dans le cas le plus courant, tous les ONT émettent sur une même longueur d'onde pour des raisons de coût.

Les réseaux d'accès optiques font l'objet de recommandations ou de standards déjà publiés ou encore en cours d'élaboration au sein de l'IEEE et de l'ITU-T, et plus particulièrement au sein du groupe FSAN. Parmi les différents standards, le EPON et le GPON émergent aujourd'hui ; ils permettent tous deux d'atteindre des débits supérieurs au Gbit/s. Ainsi, un réseau G-PON permet des débits de 2,5 Gbit/s en sens descendant et de 1,25Gbit/s en sens montant, pour 32 ou 64 clients. Un réseau d'accès avec un objectif de transmission à 10 Gbit/s est en phase de finalisation au sein de l'IEEE 802.3, de l'ITU-T SG15 Q2 et du groupe FSAN pour une version Ethernet PON.

En parallèle de ces instances se déroulent des échanges entre des acteurs économiques qui ont conduit à la définition d'un réseau d'accès WDM PON. Celui-ci se caractérise par un multiplexage en longueur d'onde WDM (en anglais, « Wave-length Division Multiplexed ») : à chaque terminal client correspond une longueur d'onde d'émission du signal attribuée par le central. En référence à la figure 2, l'OLT comprend un multiplexeur/démultiplexeur qui effectue le multiplexage/démultiplexage en longueur d'onde pour chaque terminal client et le coupleur est remplacé par un noeud d'accès RN client qui comprend un multiplexeur/démultiplexeur qui effectue le multiplexage/démultiplexage en longueur d'onde pour chaque client. Compte tenu que les ONT doivent être fabriqués en grand nombre, leur coût oriente les choix technologiques pour le déploiement des réseaux d'accès optiques. En particulier, la technologie qui permet d'obtenir des ONT identiques tout en étant compatibles d'une longueur d'onde montante configurable et spécifique à l'utilisateur peut être un bon candidat pour ces réseaux. Il est ainsi généralement considéré que les ONT doivent être sans couleur.

Une technique récente nommée « self-seeded » soit auto-accordée dont un mode de mise en oeuvre est décrit dans [1], permet une auto-organisation passive de l'allocation en longueur d'onde, plus particulièrement pour les signaux en voie montante et donc aux modules d'émission qui se trouvent dans les ONTs d'un réseau d'accès WDM PON. Cette technique illustrée par la figure 3 est basée sur l'ajout dans la cavité laser des modules d'émission des ONTs d'un composant optique partiellement réflectif, typiquement un miroir MR. Ce composant optique partiellement réflectif permet à la source lumineuse OptGain d'auto-accorder sa longueur d'onde d'émission sur le principe d'un aller-retour optique entre cette source OptGain qui est un milieu avec un gain optique et le miroir MR. Le miroir MR partiellement réflectif, fonctionne nécessairement partiellement en transmission. Typiquement la source lumineuse est un RSOA (Reflective Semi-conductor Optical Amplifier) ou un SOA associé avec un modulateur réflectif. La longueur d'onde est sélectionnée par un filtre optique, généralement un réseau AWG (Arrayed Waveguide Grating) qui coopère avec la source RSOA.

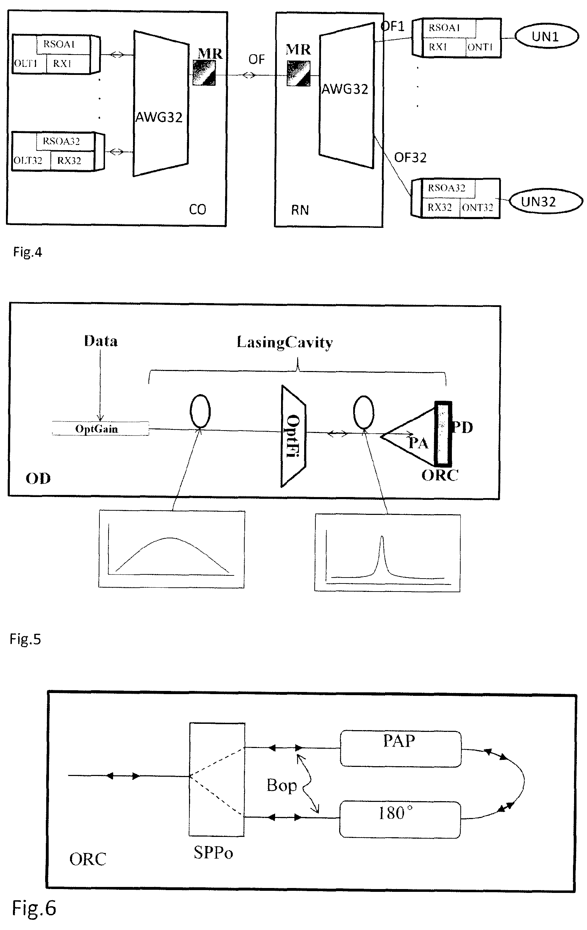

Un système utilisant cette technique auto- accordée est représenté à la figure 4. Le central CO comprend 32 équipements terminaux OLTs comprenant chacun une source RSOA auto- accordée, c'est-à-dire coopérant avec un filtre optique et un composant optique semi réfléchissant qui délimite la cavité laser avec la source, le filtre étant dans la cavité. Chaque OLT comprend en outre un récepteur pour détecter le signal montant provenant d'un ONT. Le filtre optique est un réseau AWG à 32 canaux auquel est associé un seul miroir semi réfléchissant. L'architecture du noeud d'accès client RN est symétrique de celle du central CO : 32 unités optiques ONT avec chacun une source lumineuse auto-accordée RSOA et un récepteur pour détecter le signal descendant provenant d'un OLT. Les sources auto- accordées RSOA coopèrent avec un filtre optique, un réseau AWG à 32 canaux, et un miroir semi réfléchissant MR. Les sources lumineuses RSOA émettent dans les bandes L et C respectivement pour les signaux descendants et montants.

Le principe d'auto-accordage de la longueur d'onde sur lequel est basée la technique a pour inconvénient d'introduire des pertes optiques entre le miroir et la source lumineuse. Pour que l'effet laser intervienne, il faut que le gain apporté par le milieu optique soit supérieur aux pertes dues aux différents éléments optiques.

La présente invention propose un dispositif lumineux qui soit moins sensible aux pertes optiques entre le miroir et la source lumineuse.

Ainsi, l'invention a pour objet un dispositif lumineux destiné à un réseau d'accès optique WDM PON comprenant une source lumineuse avec un milieu de gain optique, dont la longueur d'onde s'auto accorde lors d'un aller retour optique entre le milieu de gain optique et un composant optique réflectif délimitant la cavité laser caractérisé en ce que le composant optique réflectif est composé d'un amplificateur optique associé selon un montage optique réflectif à un dispositif polarisant déterminé pour que l'axe de polarisation de la lumière réfléchit soit le même que celui de la lumière émise.

Ainsi, selon l'invention le miroir semi réfléchissant utilisé dans la technique d'auto-accordage (« self-seeded ») de l'art antérieur est remplacé par un amplificateur optique associé à un dispositif polarisant déterminé sur la base d'un montage optique réflectif sur le dispositif polarisant (montage de type boucle ou montage avec miroir). La source lumineuse avec un milieu de gain optique, typiquement une source RSOA ou SOA, a une émission selon un seul axe de polarisation. La coopération entre l'amplificateur optique et le dispositif polarisant déterminé, selon l'invention, fait que le faisceau lumineux qui revient dans la source lumineuse est polarisé selon le même axe de polarisation que celui du faisceau émis. Ainsi, la polarisation du faisceau réfléchit est soit dans la même direction que celle du faisceau émis, soit dans la direction opposée (180°). La coopération conduit donc a une même polarisation modulo 180° entre les faisceaux émis et réfléchit. Le remplacement du miroir par un amplificateur optique réflectif associé à un dispositif polarisant déterminé permet avantageusement d'obtenir un gain optique et par conséquent d'augmenter la tolérance vis-à-vis de pertes optique dues aux différents composants optiques.

Selon un mode de réalisation, le montage optique réflectif fait intervenir une boucle optique entre l'amplificateur optique PA et le dispositif polarisant PD, l'amplificateur optique a une polarisation déterminée et le dispositif polarisant comprend :
- un séparateur de polarisation entre la source lumineuse et la boucle optique,
- un rotateur de polarisation de 180° qui coopère dans la boucle optique avec le séparateur de polarisation et l'amplificateur optique polarisé pour que la lumière réfléchit ait le même axe de polarisation que la lumière émise.

Selon ce mode l'ensemble formé de la source lumineuse avec le milieu de gain optique et de l'amplificateur est typiquement une source SOA polarisée de manière déterminée. Le rotateur de polarisation de 180° est un rotateur de Faraday. Ce mode est avantageux en ce que l'amplificateur optique polarisé délivre plus de gain et de puissance optique qu'un amplificateur optique indépendant de la polarisation.

Selon un mode de réalisation, le dispositif polarisant PD est réfléchissant et le montage optique réflectif est de type miroir entre l'amplificateur optique PA et le dispositif polarisant PD réfléchissant, l'amplificateur est indépendant de la longueur d'onde, le dispositif polarisant est un miroir de Faraday de 180° qui délimite la cavité laser et coopère avec l'amplificateur optique pour que l'axe de polarisation de la lumière réfléchit soit le même que celui de la lumière émise.

Selon ce mode l'amplificateur amplifie deux polarisations différentes. Ce mode présente l'avantage par rapport au précédent de ne pas nécessiter de séparateur de polarisation.

Selon un mode de réalisation, le dispositif lumineux comprend en outre un coupleur optique de puissance interposé dans le chemin du faisceau en entrée-sortie du dispositif lumineux.

Selon ce mode, le coupleur amplifie d'une part le faisceau transmis vers le dispositif terminal distant, OLT ou ONT, du réseau d'accès optique WDM PON et le faisceau provenant de ce même dispositif terminal en entrée du dispositif lumineux.

En outre, l'invention a pour objet un réseau d'accès WDM PON comprenant deux multiplexeurs/démultiplexeurs et des dispositifs lumineux comprenant une source lumineuse avec un milieu de gain optique, dont la longueur d'onde s'auto accorde lors d'un aller retour optique entre le milieu de gain optique et un composant optique réflectif délimitant la cavité laser, tel que :
- le composant optique réflectif est un amplificateur optique associé à un dispositif polarisant déterminé pour que l'axe de polarisation de la lumière réfléchit soit le même que celui de la lumière émise et
- le composant optique réflectif est commun aux dispositifs lumineux des voies montante et descendante et inséré entre les deux multiplexeurs/démultiplexeurs.

Ce mode est particulièrement adapté lorsque le milieu amplificateur, et plus généralement l'amplificateur optique dans un montage optique réflectif, dispose d'une bande passante suffisante pour couvrir aussi bien la bande passante des faisceaux de la voie montante que la bande passante des faisceaux de la voie descendante.

En outre, l'invention a pour objet un réseau d'accès WDM PON comprenant deux multiplexeur/démultiplexeurs, deux composants optiques réflectifs et des dispositifs lumineux comprenant une source lumineuse avec un milieu de gain optique, dont la longueur d'onde s'auto accorde lors d'un aller retour optique entre le milieu de gain optique et le composant optique réflectif qui délimite la cavité laser tel que :
- un composant optique réflectif est un amplificateur optique associé à un dispositif polarisant déterminé pour que l'axe de polarisation de la lumière réfléchit soit le même que celui de la lumière émise et
- les deux composants optiques réflectifs sont communs respectivement à la bande passante montante et à la bande passante descendante.

Ce mode est particulièrement adapté lorsque le milieu amplificateur, et plus généralement l'amplificateur optique, ne dispose pas d'une bande passante suffisante pour couvrir aussi bien la bande passante des faisceaux de la voie montante que la bande passante des faisceaux de la voie descendante.

Selon une mise en oeuvre particulière, le réseau comprenant en outre deux couples de démultiplexeur/démultiplexeurs tête bêches, un pour la bande passante montante et un pour la bande passante descendante, le composant optique réflectif associé à la bande passante montante délimite la cavité laser des dispositifs lumineux des clients et est inséré entre les deux démultiplexeurs d'un couple, le composant optique réflectif associé à la bande passante descendante délimite la cavité laser des dispositifs lumineux du central et est inséré entre les deux démultiplexeurs de l'autre couple.

D'autres caractéristiques et avantages de l'invention apparaîtront lors de la description qui suit faite en regard de figures annexées données à titre d'exemples non limitatifs.
La figure 1 est un schéma d'une architecture fibre optique point-multipoint passive selon l'état de l'art.
La figure 2 est un schéma d'une architecture d'un réseau d'accès WDM PON selon l'état de l'art.
La figure 3 est un schéma de principe de la technique d'auto-accordage d'une source lumineuse (typiquement RSOA ou SOA).
La figure 4 est un schéma d'une architecture d'un réseau d'accès WDM PON dans lequel est mise en oeuvre une technique d'auto-accordage de la source lumineuse selon l'état de l'art.
La figure 5 est un schéma d'une réalisation particulière d'un dispositif lumineux selon l'invention.
La figure 6 est un schéma d'un mode de réalisation particulier du composant optique réflectif ORC.
La figure 7 est un schéma d'un mode de réalisation particulier du composant optique réflectif ORC.
La figure 8 est un schéma d'une première mise en oeuvre du coupleur optique de puissance OPC en entrée-sortie du séparateur de polarisation SPPo du composant optique réflectif ORC.
La figure 9 est un schéma d'une seconde mise en oeuvre du coupleur optique de puissance OPC en entrée-sortie de l'amplificateur optique PA du composant optique réflectif ORC.
La figure 10 est un schéma d'une première mise oeuvre d'un dispositif lumineux selon l'invention dans un réseau d'accès WDM PON.
La figure 11 est un schéma d'une deuxième mise oeuvre d'un dispositif lumineux selon l'invention dans un réseau d'accès WDM PON.

Entre les différentes figures, les mêmes références et symboles sont utilisés pour désigner des choses similaires.

La figure 5 représente schématiquement un dispositif lumineux OD selon l'invention. Le dispositif lumineux OD est destiné à un réseau d'accès optique WDM PON. Plus particulièrement, le dispositif lumineux OD est destiné à être réparti d'une part dans un dispositif optique terminal ONT chez le client et d'autre part dans un noeud distant client RN ou à être réparti d'une part dans un dispositif optique terminal tel un OLT et dans un multiplexeur/démultiplexeur dans un central.

Le dispositif lumineux OD comprend une source lumineuse avec un milieu de gain optique OptGain, dont la longueur d'onde s'auto accorde lors d'un aller retour optique entre le milieu de gain optique et un composant optique réflectif ORC délimitant la cavité laser. Cette source est typiquement une source RSOA ou SOA qui fait partie d'un dispositif optique terminal OLT ou ONT respectivement dans le central ou chez le client. Le composant optique réflectif ORC est un amplificateur optique PA bidirectionnel associé selon un arrangement réflectif à un dispositif polarisant PD déterminé pour que l'axe de polarisation de la lumière réfléchit soit le même que celui de la lumière émise. Le composant optique réflectif ORC fait typiquement partie du central ou du noeud distant client. Le dispositif lumineux comprend un filtre optique OptFi classique typiquement un réseau AWG qui fait partie d'un multiplexeur/démultiplexeur qui lui-même fait partie du central ou du noeud distant client.

Selon un mode de réalisation particulier du composant optique réflectif ORC, illustré schématiquement par la figure 6, l'arrangement réflectif correspond à un montage optique de type boucle entre l'amplificateur optique PA et le dispositif polarisant PD. Selon ce mode, le montage optique réflectif fait intervenir une boucle optique entre l'amplificateur optique PA et le dispositif polarisant PD, l'amplificateur optique a une polarisation déterminée et le dispositif polarisant comprend :
- un séparateur de polarisation SPPo entre la source lumineuse et la boucle optique Bop,
- un rotateur de polarisation de 180° qui coopère dans la boucle optique Bop avec le séparateur de polarisation SPPo et l'amplificateur optique polarisé PAP pour que la lumière réfléchit ait le même axe de polarisation que la lumière émise.

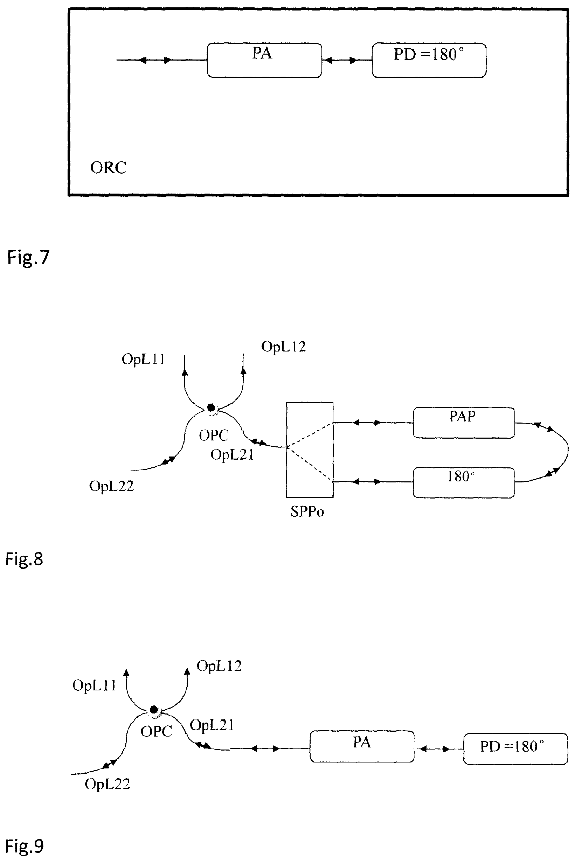

Selon un mode de réalisation particulier du composant optique réflectif ORC, illustré schématiquement par la figure 7, l'arrangement réflectif correspond à un montage optique de type miroir entre l'amplificateur optique PA et le dispositif polarisant PD. Selon ce mode, l'amplificateur PA est indépendant de la longueur d'onde et le dispositif polarisant PD est un miroir de Faraday de 180° qui délimite la cavité laser et coopère avec l'amplificateur pour que l'axe de polarisation de la lumière réfléchit soit le même que celui de la lumière émise.

Selon un mode de réalisation particulier, le dispositif lumineux comprend en outre un coupleur optique de puissance interposé dans le chemin du faisceau en entrée-sortie du dispositif lumineux.

Selon une première mise en oeuvre illustrée schématiquement par la figure 8, le coupleur optique de puissance OPC est en entrée-sortie du séparateur de polarisation SPPo. Selon une seconde mise en oeuvre, illustrée schématiquement par la figure 9, le coupleur optique de puissance OPC est en entrée-sortie de l'amplificateur optique PA.

Le coupleur optique peut être de type 2 vers 2 ou 1 vers 2. Les deux points de sortie OptL11, OptL12 sont destinés à transmettre les signaux transmis. Dans le cas d'un coupleur de type 2 vers 1, seul un point de sortie du coupleur est utilisé pour transmettre les signaux. Un des points d'entrée OptL21 du coupleur est branché en entrée/sortie du composant optique réflectif. Le second OptL22 point d'entrée est branché avec le filtre optique (non représenté sur les figures 8 et 9).

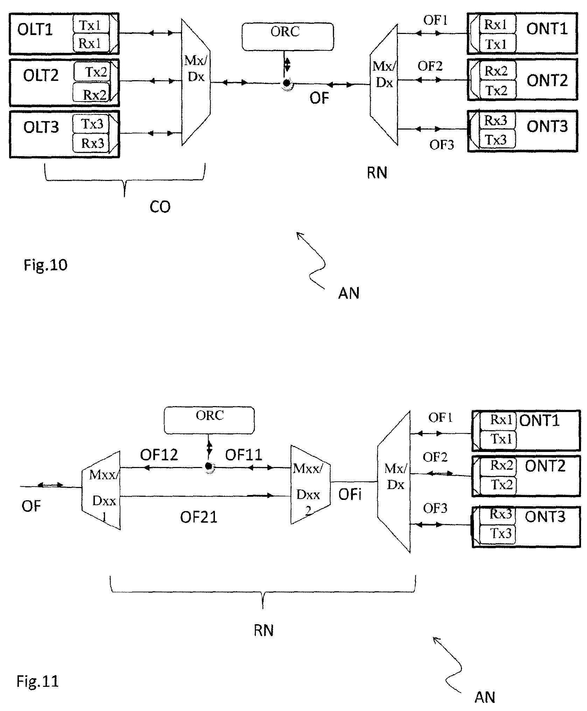

La figure 10 représente schématiquement une première mise oeuvre d'un dispositif lumineux selon l'invention dans un réseau d'accès WDM PON. Selon cette mise en oeuvre, le réseau d'accès WDM PON AN comporte entre les multiplexeurs/démultiplexeurs Mx/Dx respectivement du central CO et du noeud client distant RN un seul composant optique réflectif ORC. Cette mise en oeuvre correspond à un composant optique réflectif ORC qui possède une bande passante d'amplification au moins égale à celles utilisées pour la voie montante et la voie descendante. Selon cette mise en oeuvre, le composant optique réflectif ORC est commun aux dispositifs lumineux selon l'invention des clients ONT et du central OLT. Par exemple, les transmetteurs Tx1, Tx2, Tx3 des trois clients fonctionnent respectivement dans le rouge foncé, le rouge claire et le rouge très claire et les récepteurs Rx1, Rx2, Rx3 des trois clients fonctionnent respectivement dans le bleu foncé, le bleu clair et le bleu très clair. Les fibres optiques secondaires OF1, OF2, OF3 transmettent simultanément en voie montante et en voie descendante deux longueurs d'onde, le rouge foncé et le bleu foncé, le rouge claire et le bleu clair, le rouge très claire et le bleu très clair. Le multiplexeur/demultiplexeur Mx/Dx du noeud distant client RN comprend un filtre optique qui est typiquement un réseau AWG. Le multiplexeur/demultiplexeur Mx/Dx du noeud distant client RN multiplexe les signaux des voies montantes sur la fibre optique OF et démultiplexe les signaux des voies descendantes sur les fibres secondaires OF1, OF2 et OF3. Ainsi dans le sens descendant, le multiplexeur/démultiplexeur Mx/Dx du noeud distant client RN sépare les longueurs d'onde bleues selon les différences de teinte foncé, clair et très clair. La fonction démultiplexage du multiplexeur/démultiplexeur de chaque ONT sépare la longueur d'onde bleue en voie descendante de la longueur d'onde rouge. Le multiplexeur/démultiplexeur de chaque ONT1, ONT2 et ONT3 effectue l'adaptation du récepteur Rx1, Rx2, Rx3 et du transmetteur Tx1, Tx2, Tx3 à la fibre optique secondaire OF1, OF2 et OF3. Chaque transmetteur Tx1, Tx2, Tx3 comprend une source lumineuse avec un milieu de gain optique OptGain qui interagit avec le composant optique réflectif ORC qui délimite la cavité laser. Côté central CO, le fonctionnement est symétrique.

La figure 11 représente schématiquement une deuxième mise oeuvre d'un dispositif lumineux selon l'invention dans un réseau d'accès WDM PON. Le schéma ne comporte qu'une partie du réseau d'accès AN, la partie côté clients. La partie côté central est symétrique. Selon cette mise en oeuvre, le réseau d'accès WDM PON comporte deux multiplexeur/démultiplexeurs Mxx/Dxx1, Mxx/Dxx2 tête bêche pour séparer les voies montante et descendante et respectivement les recombiner ainsi qu'un composant optique réflectif ORC selon l'invention inséré dans la voie montante entre les multiplexeur/démultiplexeurs Mxx/Dxx1, Mxx/Dxx2.

Par exemple, les transmetteurs Tx1, Tx2, Tx3 des trois ONT1, ONT2, ONT3 fonctionnent respectivement dans le rouge foncé, le rouge claire et le rouge très claire et les récepteurs Rx1, Rx2, Rx3 des trois ONT1, ONT2, ONT3 fonctionnent respectivement dans le bleu foncé, le bleu clair et le bleu très clair. Les fibres optiques secondaires OF1, OF2, OF3 transmettent simultanément en voie montante et en voie descendante deux longueurs d'onde respectivement le rouge foncé et le bleu foncé, le rouge claire et le bleu clair, le rouge très claire et le bleu très clair. Le multiplexeur/démultiplexeur Mx/Dx comprend un filtre optique qui est typiquement un réseau AWG. Le multiplexeur/démultiplexeur Mx/Dx multiplexe les signaux des voies montantes sur la fibre optique OFi et démultiplexe les signaux des voies descendantes sur les fibres secondaires OF1, OF2 et OF3. Ainsi dans le sens descendant, le multiplexeur/démultiplexeur Mx/Dx sépare les longueurs d'onde bleues selon les différences de teinte foncé, clair et très clair. La fonction démultiplexage du multiplexeur/démultiplexeur de chaque ONT1, ONT2, ONT3 sépare la longueur d'onde bleue en voie descendante de la longueur d'onde rouge. Le multiplexeur/démultiplexeur de chaque ONT1, ONT2, ONT3 effectue l'adaptation du récepteur Rx1, Rx2, Rx3 et du transmetteur Tx1, Tx2, Tx3 à la fibre optique secondaire OF1, OF2 et OF3. Chaque transmetteur Tx1, Tx2, Tx3 comprend une source lumineuse avec un milieu de gain optique OptGain qui interagit avec le composant optique réflectif ORC qui délimite la cavité laser.

Le multiplexeur/démultiplexeur Mxx/Dxx1 sépare les voies montante et descendante transmises sur la fibre optique OF. Ainsi, le multiplexeur/démultiplexeur Mxx/Dxx1 sépare les longueurs d'ondes bleues de la voie descendante, des longueurs d'ondes rouges de la voie montante. Le multiplexeur/démultiplexeur Mxx/Dxx2 multiplexe les longueurs d'onde de la voie descendante aux longueurs d'onde de la voie montante sur la fibre optique OFi. En outre, la longueur d'onde de la source lumineuse de chaque transmetteur Tx1, Tx2, Tx3 s'auto accorde lors d'un aller retour optique entre le milieu de gain optique et le composant optique réflectif ORC qui délimite la cavité laser. Le multiplexeur/démultiplexeur Mxx/Dxx2 filtre les ondes lumineuses émises par les transmetteurs Tx1, Tx2, Tx3 lors de leur aller-retour optique dans la cavité laser délimitée par chaque transmetteur Tx1, Tx2, Tx3 et le composant optique réflectif ORC et multiplexe l'onde de retour transmise par la fibre OF11 sur la fibre OFi avec les longueurs d'onde de la voie descendante.
[1] : N. Nadarajah, et al., "Upstream access and local area networking in passive optical networks using self-seeded reflective semiconductor optical amplifier," IEEE Photon. Technol. Lett., vol. 19, no. 19, pp.1559-1561, Oct. 200

## Revendications

1. Dispositif lumineux (OLT, ONT) destiné à un réseau d'accès optique WDM PON comprenant une source lumineuse avec un milieu de gain optique, dont la longueur d'onde s'auto accorde lors d'un aller retour optique entre le milieu de gain optique et un composant optique réflectif délimitant la cavité laser **caractérisé en ce que** le composant optique réflectif est composé d'un amplificateur optique associé selon un montage optique réflectif à un dispositif polarisant déterminé pour que l'axe de polarisation de la lumière réfléchie par le composant optique réflectif soit le même que celui de la lumière émise par la source lumineuse.

2. Dispositif lumineux (OLT, ONT) selon la revendication 1 dans lequel le montage optique réflectif fait intervenir une boucle optique entre l'amplificateur optique PA et le dispositif polarisant PD, l'amplificateur optique a une polarisation déterminée et le dispositif polarisant comprend :
- un séparateur de polarisation entre la source lumineuse et la boucle optique,
- un rotateur de polarisation de 180° qui coopère dans la boucle optique avec le séparateur de polarisation et l'amplificateur optique polarisé pour que la lumière réfléchie ait le même axe de polarisation que la lumière émise.

3. Dispositif lumineux (OLT, ONT) selon la revendication 1 dans lequel le dispositif polarisant PD est réfléchissant et le montage optique réflectif est de type miroir entre l'amplificateur optique PA et le dispositif polarisant PD réfléchissant, l'amplificateur est indépendant de la longueur d'onde, le dispositif polarisant est un miroir de Faraday de 180° qui délimite la cavité laser et coopère avec l'amplificateur optique pour que l'axe de polarisation de la lumière réfléchie soit le même que celui de la lumière émise.

4. Dispositif lumineux (OLT, ONT) selon la revendication 2 ou 3, comprenant en outre un coupleur optique de puissance (OPC) interposé dans le chemin du faisceau en entrée-sortie du dispositif lumineux.

5. Réseau d'accès WDM PON (AN) comprenant deux multiplexeurs/démultiplexeurs (Mx/Dx) et des dispositifs lumineux (OLT, ONT) comprenant une source lumineuse avec un milieu de gain optique, dont la longueur d'onde s'auto accorde lors d'un aller retour optique entre le milieu de gain optique et un composant optique réflectif (ORC) délimitant la cavité laser **caractérisé en ce que** :
- le composant optique réflectif est un amplificateur optique (PA) associé à un dispositif polarisant déterminé (PD) pour que l'axe de polarisation de la lumière réfléchie soit le même que celui de la lumière émise et
- le composant optique réflectif est commun aux dispositifs lumineux des voies montante et descendante et inséré entre les deux multiplexeurs/démultiplexeurs.

6. Réseau d'accès WDM PON (AN) comprenant deux multiplexeur/démultiplexeurs (Mx/Dx), deux composants optiques réflectifs (ORC) et des dispositifs lumineux (OLT, ONT) comprenant une source lumineuse avec un milieu de gain optique, dont la longueur d'onde s'auto accorde lors d'un aller retour optique entre le milieu de gain optique et le composant optique réflectif qui délimite la cavité laser **caractérisé en ce que** :
- un composant optique réflectif est un amplificateur optique associé à un dispositif polarisant déterminé pour que l'axe de polarisation de la lumière réfléchie soit le même que celui de la lumière émise et
- les deux composants optiques réflectifs sont communs respectivement à la bande passante montante et à la bande passante descendante.

7. Réseau d'accès WDM PON (SS) selon la revendication 6, comprenant en outre deux couples de démultiplexeur/démultiplexeurs (Mxx/Dxx1, Mxx/Dxx2) tête bêches, un pour la bande passante montante et un pour la bande passante descendante, le composant optique réflectif associé à la bande passante montante délimite la cavité laser des dispositifs lumineux des clients et est inséré entre les deux démultiplexeurs d'un couple, le composant optique réflectif associé à la bande passante descendante délimite la cavité laser des dispositifs lumineux du central et est inséré entre les deux démultiplexeurs de l'autre couple.

## Patentansprüche

1. Leuchtvorrichtung (OLT, ONT), die für ein optisches WDM-PON-Zugangsnetz bestimmt ist, umfassend eine Lichtquelle mit einem optischen Verstärkungsmedium, deren Wellenlänge sich bei einer optischen Hin- und Herbewegung zwischen dem optischen Verstärkungsmedium und einer reflektierenden optischen Komponente, die den Laserhohlraum begrenzt, selbst anpasst, **dadurch gekennzeichnet, dass** die reflektierende optische Komponente aus einem optischen Verstärker besteht, der in einer reflektierenden optischen Montage einer bestimmten polarisierenden Vorrichtung zugeordnet ist, so dass die Polarisationsachse des von der reflektierenden optischen Komponente reflektierten Lichts dieselbe wie jene des von der Lichtquelle entsandten Lichts ist.

2. Leuchtvorrichtung (OLT, ONT) nach Anspruch 1, bei der die reflektierende optische Montage eine optische Schleife zwischen dem optischen Verstärker PA und der polarisierenden Vorrichtung PD einsetzt, der optische Verstärker eine bestimmte Polarisation hat und die polarisierende Vorrichtung umfasst:
- einen Polarisationsteiler zwischen der Lichtquelle und der optischen Schleife,
- einen Polarisationsrotator um 180°, der in der optischen Schleife mit dem Polarisationsteiler und dem polarisierten optischen Verstärker zusammenwirkt, so dass das reflektierte Licht dieselbe Polarisationsachse wie das entsandte Licht hat.

3. Leuchtvorrichtung (OLT, ONT) nach Anspruch 1, bei der die polarisierende Vorrichtung PD reflektierend ist, und die reflektierende optische Montage vom Typ Spiegel zwischen dem optischen Verstärker PA und der reflektierenden polarisierenden Vorrichtung PD ist, der Verstärker von der Wellenlänge unabhängig ist, die polarisierende Vorrichtung ein Faraday'scher Spiegel von 180° ist, der den Laserhohlraum begrenzt und mit dem optischen Verstärker zusammenwirkt, so dass die Polarisationsachse des reflektierten Lichts dieselbe wie jene des entsandten Lichts ist.

4. Leuchtvorrichtung (OLT, ONT) nach Anspruch 2 oder 3, ferner umfassend einen optischen Leistungskoppler (OPC), der auf dem Weg des Lichtstrahls am Eingang-Ausgang der Leuchtvorrichtung angeordnet ist.

5. WDM-PON-Zugangsnetz (AN), umfassend zwei Multiplexer/Demultiplexer (Mx/Dx) und Leuchtvorrichtungen (OLT, ONT), umfassend eine Lichtquelle mit einem optischen Verstärkungsmedium, deren Wellenlänge sich bei einer optischen Hin- und Herbewegung zwischen dem optischen Verstärkungsmedium und einer reflektierenden optischen Komponente (ORC), die den Laserhohlraum begrenzt, selbst anpasst, **dadurch gekennzeichnet, dass**:
- die reflektierende optische Komponente ein optischer Verstärker (PA) ist, der einer bestimmten polarisierenden Vorrichtung (PD) zugeordnet ist, so dass die Polarisationsachse des reflektierten Lichts dieselbe wie jene des entsandten Lichts ist, und
- die reflektierende optische Komponente den Leuchtvorrichtungen der aufsteigenden und absteigenden Wege gemeinsam ist und zwischen den beiden Multiplexern/Demultiplexern eingesetzt ist.

6. WDM-PON-Zugangsnetz (AN), umfassend zwei Multiplexer/Demultiplexer (Mx/Dx), zwei reflektierende optische Komponenten (ORC) und Leuchtvorrichtungen (OLT, ONT), umfassend eine Lichtquelle mit einem optischen Verstärkungsmedium, deren Wellenlänge sich bei einer optischen Hin- und Herbewegung zwischen dem optischen Verstärkungsmedium und der reflektierenden optischen Komponente, die den Laserhohlraum begrenzt, selbst anpasst, **dadurch gekennzeichnet, dass**:
- eine reflektierende optische Komponente ein optischer Verstärker ist, der einer bestimmten polarisierenden Vorrichtung zugeordnet ist, so dass die Polarisationsachse des reflektierten Lichts dieselbe wie jene des entsandten Lichts ist, und
- die beiden reflektierenden optischen Komponenten der aufsteigenden Bandbreite bzw. der absteigenden Bandbreite gemeinsam ist.

7. WDM-PON-Zugangsnetz (SS) nach Anspruch 6, ferner umfassend zwei Paare von hintereinander geschalteten Demultiplexern/Demultiplexern (Mxx/Dxx1, Mxx/Dxx2), einen für die aufsteigende Bandbreite und einen für die absteigende Bandbreite, wobei die reflektierende optische Komponente, die der aufsteigenden Bandbreite zugeordnet ist, den Laserhohlraum der Leuchtvorrichtungen der Kunden begrenzt und zwischen den beiden Demultiplexern eines Paars eingesetzt ist, wobei die reflektierende optische Komponente, die der absteigenden Bandbreite zugeordnet ist, den Laserhohlraum der Leuchtvorrichtungen der Zentrale begrenzt und zwischen den beiden Demultiplexern des anderen Paars eingesetzt ist.

## Claims

1. Luminous device (OLT, ONT) intended for a WDM PON optical access network comprising a luminous source with an optical gain medium, whose wavelength self-tunes during an optical outward-return journey between the optical gain medium and a reflective optical component delimiting the laser cavity, **characterized in that** the reflective optical component is composed of an optical amplifier associated according to a reflective optical setup with a polarizing device determined so that the axis of polarization of the light reflected by the reflective optical component is the same as that of the light emitted by the luminous source.

2. Luminous device (OLT, ONT) according to Claim 1, in which the reflective optical setup involves an optical loop between the optical amplifier PA and the polarizing device PD, the optical amplifier has a determined polarization and the polarizing device comprises:
- a polarization splitter between the luminous source and the optical loop,
- a 180° polarization rotator which cooperates in the optical loop with the polarization splitter and the polarized optical amplifier so that the reflected light has the same polarization axis as the emitted light.

3. Luminous device (OLT, ONT) according to Claim 1, in which the polarizing device PD is reflecting and the reflective optical setup is of mirror type between the optical amplifier PA and the reflecting polarizing device PD, the amplifier is independent of the wavelength, the polarizing device is a 180° Faraday mirror which delimits the laser cavity and cooperates with the optical amplifier so that the axis of polarization of the reflected light is the same as that of the emitted light.

4. Luminous device (OLT, ONT) according to Claim 2 or 3, furthermore comprising an optical power coupler (OPC) interposed in the path of the beam as input-output of the luminous device.

5. WDM PON access network (AN) comprising two multiplexers/demultiplexers (Mx/Dx) and luminous devices (OLT, ONT) comprising a luminous source with an optical gain medium, whose wavelength self-tunes during an optical outward-return journey between the optical gain medium and a reflective optical component (ORC) delimiting the laser cavity, **characterized in that**:
- the reflective optical component is an optical amplifier (PA) associated with a polarizing device (PD) determined so that the axis of polarization of the reflected light is the same as that of the emitted light and
- the reflective optical component is common to the luminous devices of the upgoing and downgoing pathways and inserted between the two multiplexers/demultiplexers.

6. WDM PON access network (AN) comprising two multiplexer/demultiplexers (Mx/Dx), two reflective optical components (ORC) and luminous devices (OLT, ONT) comprising a luminous source with an optical gain medium, whose wavelength self-tunes during an optical outward-return journey between the optical gain medium and the reflective optical component which delimits the laser cavity, **characterized in that**:
- a reflective optical component is an optical amplifier associated with a polarizing device determined so that the axis of polarization of the reflected light is the same as that of the emitted light and
- the two reflective optical components are common respectively to the upgoing passband and to the downgoing passband.

7. WDM PON access network (SS) according to Claim 6, furthermore comprising two pairs of demultiplexer/demultiplexers (Mxx/Dxxl, Mxx/Dxx2) head to tail, one for the upgoing passband and one for the downgoing passband, the reflective optical component associated with the upgoing passband delimits the laser cavity of the luminous devices of the clients and is inserted between the two demultiplexers of one pair, the reflective optical component associated with the downgoing passband delimits the laser cavity of the luminous devices of the central facility and is inserted between the two demultiplexers of the other pair.
